# EUROPEAN PATENT SPECIFICATION

(11) **EP 1 858 161 B1**
(45) Date of publication and mention of the grant of the patent: **09.12.2009**
(21) Application number: 06027031.1
(22) Date of filing: 28.12.2006
(51) Int. Cl.: H03G 3/30, H03G 1/00

(54) **Dual power mode transmitter**
Sender mit zwei Leistungsbetriebsarten
Émetteur comportant deux modes de puissance

(30) Priority: 19.05.2006 US 801399 P; 31.07.2006 US 495675
(43) Date of publication of application: 21.11.2007
(73) Proprietor: Broadcom Corporation, Irvine, CA 92617 (US)
(72) Inventor: Pan, Meng-An, Irvine, California 92618-7013 (US)
(74) Representative: Jehle, Volker Armin

(56) References cited:
- EP-A- 1 467 481
- EP-A- 1 484 840
- EP-A1- 0 977 354
- DE-A1-102004 039 830
- US-A1- 2002 008 576

## Description

### Field of the Invention

The present invention relates to dual power mode transmitter. Specifically, the invention relates to a transmitter capable of operating in a normal power mode and a low power mode.

### Background of the Invention

Battery size is one of the main constraints that limits how small mobile devices can be made. One way to design around this limitation and to make a mobile device even smaller is to use a small battery and at the same time increase the power efficiency of the mobile device. In mobile devices equipped with wireless communication such as mobile phones, personal digital assistants (PDAs), and laptops, the amplifying stage in such systems is typically one of the main circuit elements that drain the most power.

Generally, mobile devices include an amplifying stage that consists of a programmable gain amplifier or a buffer, a power amplifier driver or driver-amplifier, and a power amplifier. The amplifying stage is typically configured to provide a certain power output that is optimized for the mobile device's purpose. This power output optimization is, however, constant. Thus, when the mobile device enters a low power mode, the amplifying stage still consumes the same amount of power as if it is in a normal or high power mode.

Accordingly, it is desirable to have an amplifying stage with various power operating modes such as normal and low power modes. It is further desirable to have an amplifying stage that consumes less power while in the low power mode.

European patent application 1 467 481 A1 discloses a power amplifying circuit and a corresponding method for amplifying an RF input signal with respect to a specified RF output power. The circuit comprises an input terminal and an output terminal and an amplification path formed therebetween. The amplification path comprises a power amplification circuit for amplifying a provided input signal and a bypass formed between the input and the output terminals for bypassing the amplification path. A control terminal controls the operation of the amplification path and the bypass such, that the provided RF input signal is either passed through the amplification path or the bypass.

European patent application 1 484 840 A2 discloses a multi-stage, variable gain amplifier, which includes a primary cascoded pair of transistors for producing a primary output current from an input voltage as a function of a primary cascode control voltage. Said amplifier furthermore comprises one or more secondary cascoded pairs of transistors coupled to the primary cascaded pair of transistors for producing one or more secondary output currents from the input voltage as a function of one or more secondary cascode control voltages. The output current of the RF circuit is a sum of the primary output current and the one or more secondary output currents.

According to an aspect of the invention a radio frequency (RF) transmitter is described, said transmitter comprising a programmable gain stage configured to output a RF signal having a given power level and a variable amplifying stage coupled to the programmable gain stage. The variable amplifying stage is configured to receive the RF signal having the given power level and to adjustably amplify the RF signal to generate an amplified signal having a variable output power level. Said variable amplifying stage consists of a first plurality of cascode stages, each stage of the first plurality of cascode stages including a first transistor and a second transistor, the first transistor having a drain coupled to a first node and a gate coupled to a bias control circuit, the second transistor having a drain coupled to a source of the first transistor, a source coupled to a second node Vss and a gate coupled to a first portion of the RF signal, and a second plurality of cascode stages, each stage of the second plurality of cascode stages including a third transistor and a fourth transistor, the third transistor having a drain coupled to a third node and a gate coupled to the bias control circuit, the fourth transistor having a drain coupled to a source of the third transistor, a source coupled to the second node and a gate coupled to a second portion of the RF signal, wherein an equal number of cascode stages from each of the first and second plurality of cascode stages is biased.

Advantageously the variable amplifying stage is a variable driver amplifier configured to drive a transformer.

Advantageously the first portion of the RF signal is an in-phase signal portion of the RF signal and the second portion of the RF signal is 90° out of phase with respect to the first portion.

Advantageously the bias control circuit biases the equal number of cascode stages from each of the first and second plurality of cascode stages to adjust a respective output current at the first and third nodes.

Advantageously each transistor in each of the cascode stages is approximately the same size, or each cascode stage is different in size with respect to each other.

### Brief description of the Drawings/Figures

The present invention is described with reference to the accompanying drawings.

FIG. 1 illustrates a block circuit diagram of a transmitter.

FIG. 2A illustrates a chart showing the relationship between input and output power of an amplifier.

FIG. 2B illustrates the relationship between frequency amplitude and time in various operating modes of an amplifier.

FIG. 3 illustrates a chart showing the relationship between input and output power of an amplifier.

FIG. 4 illustrates a chart showing the relationship between input and output power of an amplifier in various modes.

FIG. 5A illustrates a block circuit diagram of a transmitter according to an embodiment of the present invention.

FIG. 5B illustrates a block circuit diagram of the transmitter in FIG. 5A in an exemplary application environment.

FIG. 6 illustrates a differential amplifier implemented by the transmitter shown in FIG. 1.

FIG. 7A illustrates a circuit diagram of a differential input stage in accordance to an embodiment of the present invention.

FIG. 7B illustrates a circuit diagram of a differential input stage in accordance to another embodiment of the present invention.

FIG. 8 illustrates a chart showing the relationship between input and output power of an amplifier in the transmitter shown in FIG. 5A.

### Detailed Description of the Invention

This specification discloses one or more embodiments that incorporate the features of this invention. The embodiment(s) described, and references in the specification to "one embodiment", "an embodiment", "an example embodiment", etc., indicate that the embodiment(s) described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is understood that it is within the knowledge of one skilled in the art to effect such feature, structure, or characteristic in connection with other embodiments whether or not explicitly described. An embodiment of the present invention is now described. While specific methods and configurations are discussed, it should be understood that this is done for illustration purposes only. A person skilled in the art will recognize that other configurations and procedures may be used without departing from the spirit and scope of the invention..

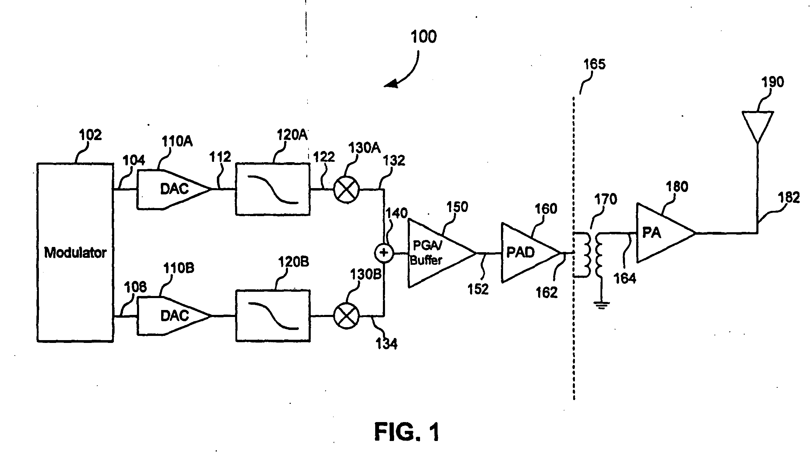

FIG. 1 illustrates a wireless transmitter 100 that includes a modulator 102, a pair of digital to analog converters 110A and 110B (DAC), a pair of low pass filters 120A and 120B, a summer 140, a programmable gain amplifier or buffer stage 150, an power amplifier driver or driver-amplifier 160, a transformer 170, a power amplifier 180; and an antenna 190.

Modulator 102 is adapted to receive and encode raw data signals (not shown). After modulating and encoding the raw data signals, modulator 102 outputs an in-phase (I) data signal 104 and a quadrature-phase (Q) data signal 106. Data signals 102 and 104 can be signals evenly spaced from an intermediate frequency (IF) or can be baseband signals.

DAC 110A is set to receive signals 104 and convert them into analog signals 112 which are supplied to low pass filter 120A. Filter 120 is used to reject unwanted frequency portions of signals 112. The signals passed by filter 120A are then directed to mixer 130A as signals 122.

Mixer's 130A main function is to up-convert signals 122. The up-conversion is done by mixing signals 122 with signals from a local oscillator (not shown). Once the up-conversion is completed, mixer 130A passes the up-converted signals 132 to summer 140. The functionalities of DAC 110B, low pass filter 120B, and mixer 130B are similar to the functionalities of DAC 110A, filter 120A, and mixer 130A. The main distinction is the processing of Q signals instead of I signals.

As shown in FIG. 1, summer 140 is coupled to mixers 130A and 130B. Summer 140 is configured to receive signals from both mixers 130A and 130B. Summer 140 combines signals 132 and 134 to produce signals 142, which are feed to programmable gain amplifier (PGA) 150.

The buffer stage or PGA 150 has 2 main functions. One of the main functions is to serve as an impedance variations isolator between all of the circuit elements to the left of PGA 150 (summer 140, mixers 130A-B, filters 120A-B, DACs 110A-B) and the power amplifier driver (PAD) 160. The other function is to provide the proper amount of signal amplification in order for PAD 160 and power amplifier 180 to produce a required amount of output power.

Transmitter 100 further includes PAD 160 that amplifies output of PGA/buffer 150. PAD 160 provides pre-amplified signals 162 at a specific power amount to enable power amplifier 180 to output amplified signals 182 with a predetermined amount of power. In transmitter 100, transformer 170 matches the impedance at the output PAD 160 with the input of power amplifier 180. Transformer 170 also converts differential signals 162 outputted by PAD 160 into single-ended signals 164. Once signals 164 are amplified by power amplifier 180, the signals are then transmitted by antenna 190.

As shown in FIG. 1, line 165 shows which portion of transmitter 100 is on-chip and which portion is off-chip. Power amplifier 180 is typically located off chip. However, transmitter 100 could be also configured such that power amplifier 180 is located on chip.

Transmitter 100 can be configured to work with various multiplexing systems such as time division multiple access (TDMA), code division multiple access (CDMA), and orthogonal frequency division multiplexing (OFDM). In one embodiment of an OFDM application, power amplifier driver 160 is typically adapted to output at approximately 6 dBm. As a design rule of thumb, the 1-dB compression point of power amplifier driver 160 should be 10 dBm above the operating output level. It follows that power amplifier driver 160 in an OFDM system should have a 1-dB compression point at 16 dBm.

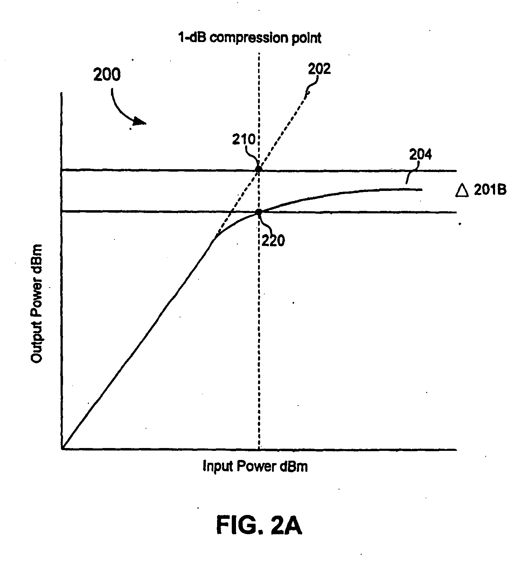

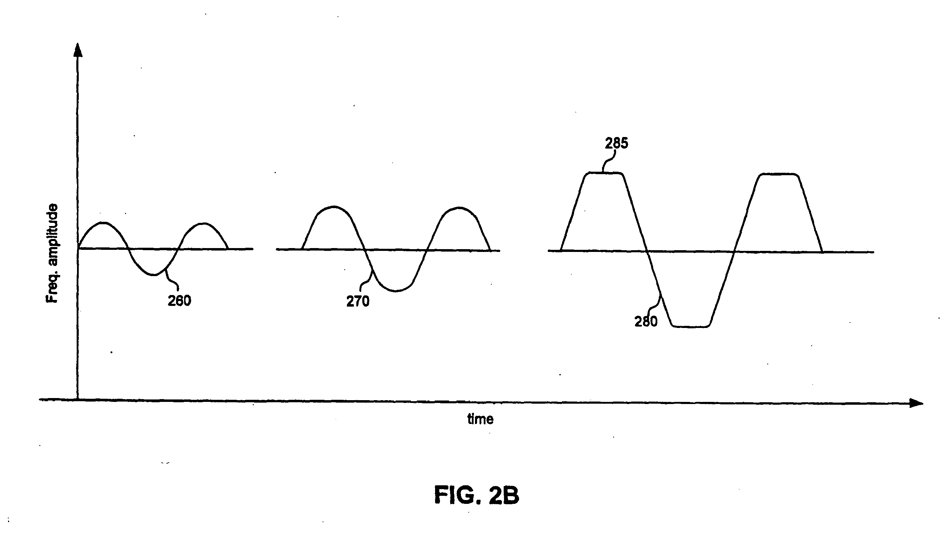

At the 1-dB compression point, power amplifier driver 160 starts to go into compression mode. FIG. 2A illustrates an input power vs. output power chart in dBm. Line 202 is the power gain line of an ideal amplifier. Line 204 is the power gain line of a typical amplifier such as power amplifier 180. As shown in FIG. 2, point 220 shows the start of the 1-dB compression point for power amplifier driver 160. Power amplifier driver 160 remains in the linear operating region for any datum point to the left of point 220. To the right of datum point 220, power amplifier driver 160 is non-linear. The 1-dB compression point is determined by finding the input power value where there is a 1 dB difference between the ideal amplifier and non-ideal amplifier output power. In this case, point 210 is approximately 1 dB higher than point 220.

FIG. 2B illustrates a signal at various stages of amplification in the time domain. Signal 260 is an un-amplified signal. Signal 270 is an amplified signal of signal 260 with the power amplifier operating in the linear region. Signal 280 is an amplified signal of 260 with the power amplifier in compression. As shown in FIG. 2B, signal 280 has a clipped portion 285 near the peak of its amplitude. When clipping occurs during the amplification of a data signal, data will be lost or adversely affected.

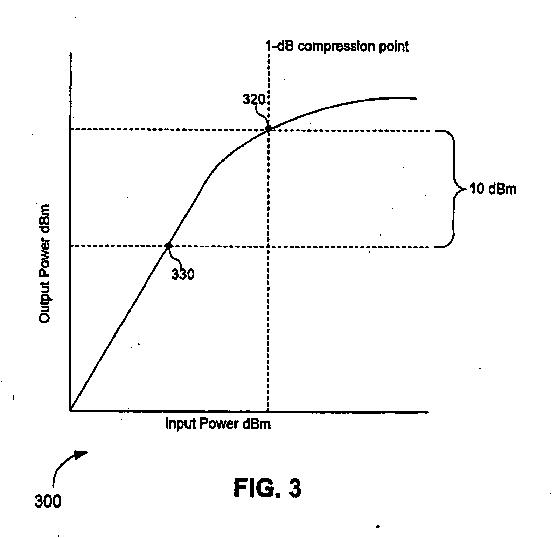

FIG. 3 illustrates a gain chart showing the operating region of power amplifier 180. Point 320 shows the 1-dB compression point. For OFDM application, a power amplifier is selected to have a 1-dB compression point of approximately 16 dBm. Point 330 is the 6 dBm point; the desired power output of power amplifier driver 160. The 10 dB buffer between points 320 and 330 serves to prevent data loss, which is especially useful for 802.11 a, 802.11b, 802.11 g, and OFDM data signals.

As mentioned, for normal operation, power amplifier driver 160 is set to output approximately 6 dBm. However, for certain lower power application, power amplifier driver 160 only needs to output 0 dBm, which is approximately 1 mW. In another exemplary low power application, power amplifier driver 160 only needs to output -5 dBm. In these low power scenarios, high power output is not necessary because an external power amplifier is likely used to augment the signals' power level to a desired level.

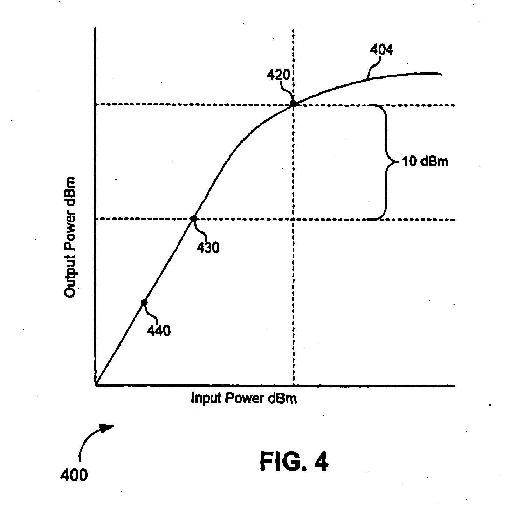

FIG. 4 illustrates how low power mode is generally achieved. Point 430 is the 6 dBm operating point, shown with respect to the 1-dB compression point 420 and 0 dBm operating point 440. Generally, one can reduce the power output of power amplifier driver 160 by reducing the input signals at the input of power amplifier driver 160. Even though the signal amplitude or intensity at the input of power amplifier driver 160 may be reduced, the current consumption of driver-amplifier 160 remains the same. Consequently, the power consumption of the power amplifier driver 160 is the same for both normal and low power modes.

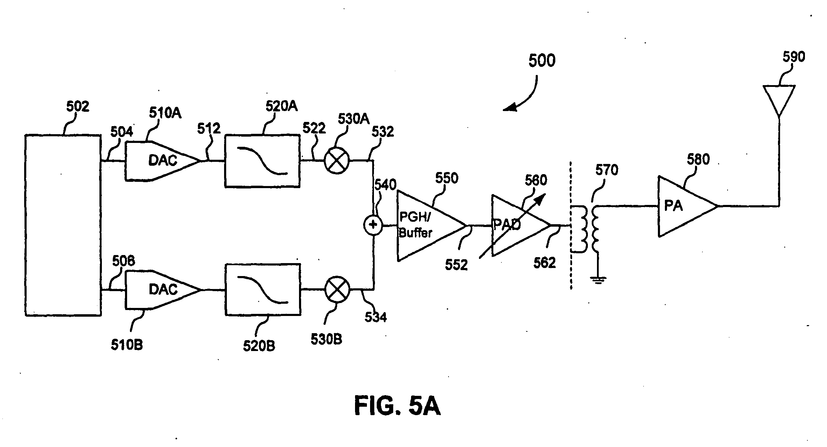

FIG. 5A illustrates a wireless transmitter 500 according to an embodiment of the present invention. Transmitter 500 that includes a modulator 502, a pair of digital to analog converters 510A and 510B (DAC), a pair of low pass filters 520A and 520B, a summer 540, a programmable gain amplifier or buffer stage 550, a variable power amplifier driver or variable driver-amplifier 560, a transformer 570, a power amplifier 580, and an antenna 590.

Modulator 502 is adapted to receive and encode raw data signals (not shown). After modulating and encoding the raw data signals, modulator 502 outputs an in-phase (I) data signals 504 and a quadrature-phase (Q) data signals 506. Data signals 502 and 504 can be signals evenly spaced from an intermediate frequency (IF) or can be baseband signals.

DAC 510A is set to receive signals 504 and convert them into analog signals 512 which are supplied to low pass filter 520A. Filter 550 is used to reject unwanted frequency portions of signals 512. The signals passed by filter 520A are then directed to mixer 530A as signals 522.

Mixer's 530A main function is to up-convert signals 522. The up-conversion is done by mixing signals 522 with signals from a local oscillator (not shown). Once the up-conversion is completed, mixer 530A passes the up-converted signals 532 to summer 540. The functionalities of DAC 510B, low pass filter 520B, and mixer 530B are similar to the functionalities of DAC 510A, filter 520A, and mixer 530A. The main distinction is the processing of quadrature (Q) signals instead of in-phase (I) signals.

Summer 540 is coupled to mixers 530A and 530B. Summer 540 is configured to receive signals from both mixers 530A and 530B. Summer 540 combines signals 532 and 534 to produce signals, which are feed to programmable gain amplifier (PGA) 550.

The buffer stage or PGA 550 has 2 main functions. One of the main functions is to serve as an impedance variations isolator between all of the circuit elements to the left of PGA 550 (summer 540, mixers 530A-B, filters 520A-B, DACs 510A-B) and the power amplifier driver (PAD) 560. The other function is to provide the proper amount of signal amplification in order for PAD 560 to produce the required amount of output power.

Transmitter 500 further includes variable PAD 560 with selectable power output. In low power mode, variable PAD's 560 circuitry is re-configured through internal switching means to provide a lower powered pre-amplified signal while pulling less current from the battery. This re-configuration may be done in real-time when PAD 560 is in use, or after the manufacturing of PAD 560. In contrast, PAD 160 maintains the same amount of current usage regardless of whether transmitter 100 is in normal or low power mode.

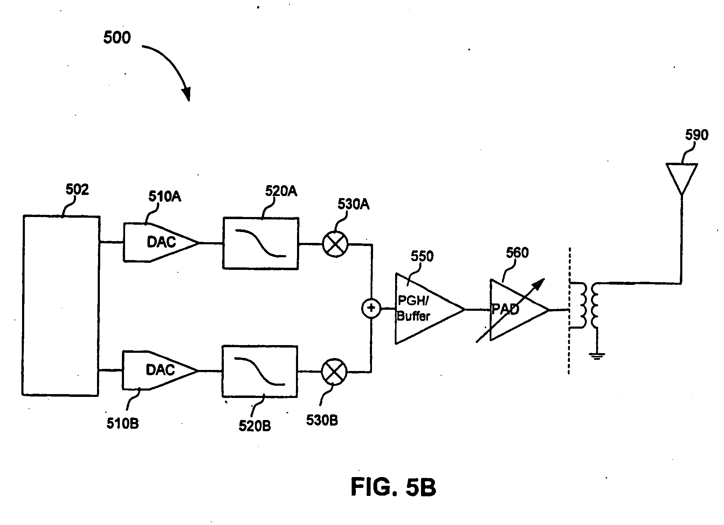

FIG. 5B illustrates transmitter 500 in an exemplary normal power mode (non-low power mode) application where no external power amplifier is needed. As shown in FIG. 5B, the output signals of PAD 560 are not amplified. When transmitter 500 is in normal power mode, it is operating with high linearity. In certain applications where the intended receiver is at a close range, high linearity is required from PAD 560 to ensure that the signal's strength is strong enough to reach the receiver because in such application an external power amplifier is not used.

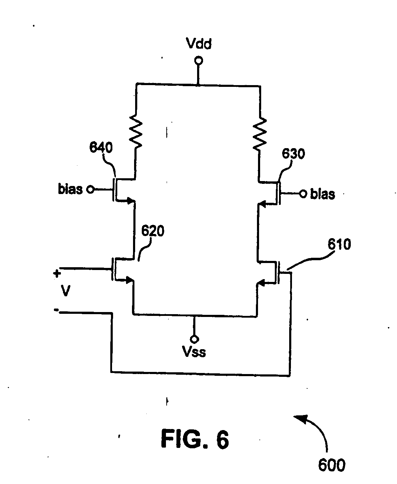

FIG. 6 illustrates an exemplary differential input stage 600 implemented in PAD 160 of transmitter 100. Differential input stage 600 is a cascode input stage that is optimized such that PAD 160 output is at approximately 6 dBm. In low power mode, where the output of PAD 160 is adjusted down to 0 dBm, differential input stage 600 outputs a lower power signal, but the current usage of input stage 600 remains the same.

Differential input stage 600 includes transistors 610, 620, 630, and 640. The gates of transistors 630 and 640 are commonly biased by a biasing source (not shown). The gates of transistors 610 and 620 are coupled to differential input signals 152 from programmable gain amplifier 150. Differential input stage 600 produces a differential current pair based on differential input signals 552. The magnitude of the each differential current depends on the relative size of transistor pairs 610, 630 and 620, 640. Generally, the size of transistor pairs 610, 630 and 620, 640 are selected such that power amplifier driver 160 yields the desired power output. As a result, the current consumption of the two transistor pairs remains constant whether or not transmitter 100 is in normal or low power mode.

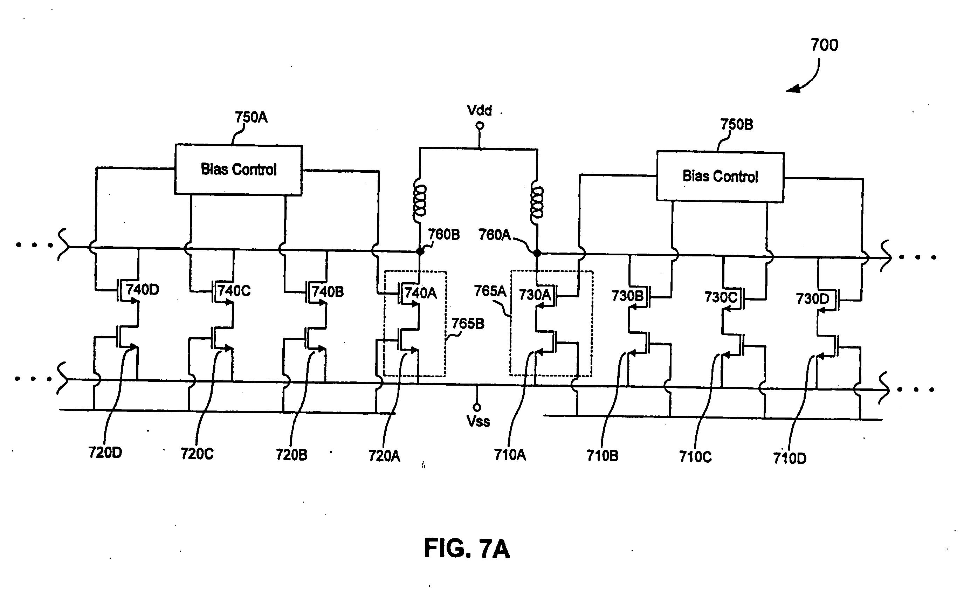

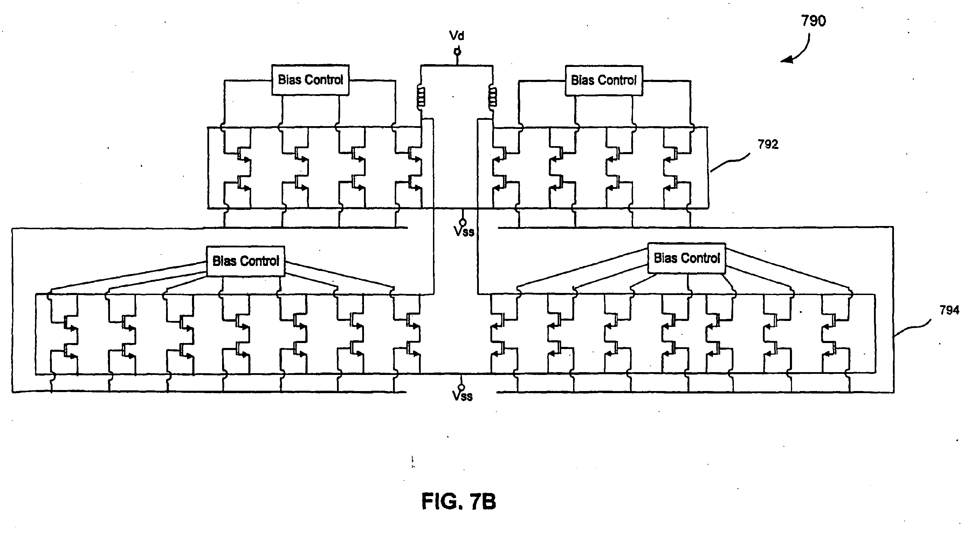

FIG. 7A illustrates a differential cascode input stage 700 that is implemented in one embodiment of variable PAD 560. Differential input stage 700 comprises many cascode input stages coupled in parallel. Differential input stage 700 includes transistors 710A-D, 720A-D, 730A-D, and 740A-D. Transistors 720A and 740A, together, form an input stage. Similarly, transistors 710A and 730A form another input stage. The gates of transistors 710A-D receive a portion of differential pre-amplified signals 552 (e.g. quadrature portion). Similarly, the gates of transistors 720A-D receive another portion of differential pre-amplified signals 552 (e.g. in-phase portion). Each gate of transistors 730A-D and 740A-D is biased by a bias control circuits 750A and 750B. Although bias control circuits 750A and 750B are shown as two separate circuits in FIG. 7, bias control circuit 750A-B can be implemented as a single circuit.

In differential input stage 700, bias control circuit 750 biases the gates of transistors 730A-D and 740A-D in pair such that an equal number amount of transistor is biased on each differential branch. For example, if the gate of transistor 730A is biased, then the gate of transistor 740A is also biased. In another example, if the gates of transistors 730A-B are biased, then the gates of transistors 740A-B are also biased. In this way, differential input stage 700 can output two approximately equal differential currents-one on each differential branch. Other biasing arrangement could be utilized based on discussions given herein.

The multiple cascode input stages configuration of differential input stage 700 allows variable PAD 560 to selectively turn on and off one or more cascode stages as desired. As mentioned, an equal amount of cascode stage must be selected to be active on each differential side of the amplifier. This configuration allows variable PAD 560 to turn on as many cascode branches as needed to meet a specified amount of power output. For example, if the maximum power output is desired such that PAD 560 outputs 6 dBm, then variable PAD 560 will select all of the cascode branches. Selection of a cascode branch is done through biasing control circuit 750. Cascode branches that are selected to be active will be biased; cascode branches not biased will be off. Stated another way, corresponding pair of transistors 730A-D and 740A-D are biased on/off to provide a desired gain and output power.

When transmitter 500 is in low power mode, bias control circuits 750A-B will select a number of cascode branches required for 0 dBm output. The size of each of the transistors in the cascode branches will determine the amount of branches to be turned on. For example, cascode branches 765A-B could be optimized to allow power amplifier 580 to output approximately 0 dBm. In this situation, bias control circuit 750A-B will bias the gate of transistor 740A and 730A, respectively. When this occurs, the differential signal input at the gate of transistor 710A will drive transistors 710A and 730A and causes a current flow through output node 760A. Similarly, the differential signal input at the gate of transistor 720A will drive transistors 720A and 740A and causes a current flow through output node 760B. Further, by limiting the number of transistors being biased, variable PAD 560 can effectively control the amount of current being drawn from the power supply. In this way, power saving may be realized by reducing the current usage in low power mode.

In an alternative embodiment, differential input stage 700 can have multiple levels of cascode stages such as differential input stage 790, shown in FIG. 7B. Instead of having one level of parallely connected cascode stages, differential input stage 790 has two levels of cascode stages, 792 and 794. In this way, the power output of differential input stage 790 can be more accurately controlled by turning on and off a certain amount of cascode branches within any level or by turning on and off the cascode branches of a level or levels as a whole.

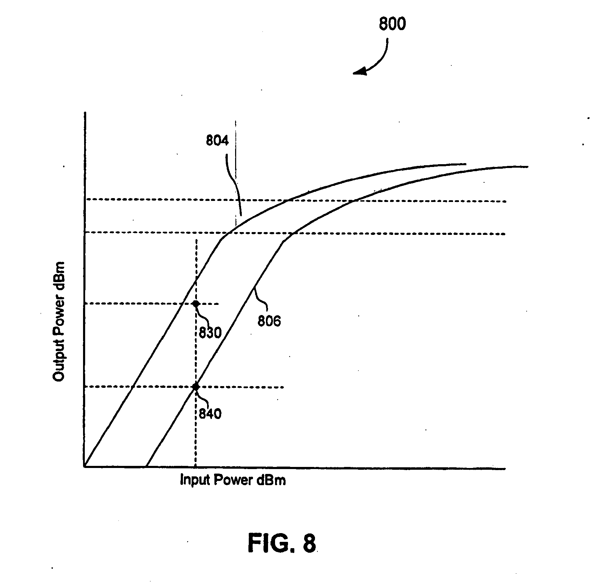

FIG. 8 illustrates the gain curve for power amplifier 580. Line 804 shows the gain curve of power amplifier 580 in normal or high power mode with point 830 as the 6 dBm point. Line 806 shows the gain curve in low power mode with point 840 as the 0 dBm point. This translates into an overall low powered amplifying stage as opposed to driving a more powerful amplifying stage with less intensity as being implemented in the amplifying stage of FIG. 4.

Even though the present invention is described in the context of npn transistors, it should be understood by one skilled in the art that other types of transistor could also be used to implement the invention.

### Conclusion

While various embodiments of the present invention have been described above, it should be understood that they have been presented by way of example only, and not limitation. It will be apparent to persons skilled in the relevant art that various changes in form and detail can be made therein. Thus, the breadth of the present invention should not be limited by any of the above-described exemplary embodiments, but should be defined only in accordance with the following claims and their equivalents.

## Claims

1. A radio frequency (RF) transmitter (500) comprising:
a programmable gain stage (550) configured to output a differential RF signal having a given power level; and
a variable amplifying stage (560) coupled to the programmable gain stage, the variable amplifying stage configured to receive the RF signal having the given power level and adjustably amplify the RF signal to generate an amplified signal having a variable output power level,
**characterized in that**
the variable amplifying stage consists of a first plurality of cascode stages, each stage of the first plurality of cascode stages including a first transistor (740) and a second transistor (720), the first transistor having a drain coupled to a first node (760B) and a gate coupled to a bias control circuit (750), the second transistor having a drain coupled to a source of the first transistor, a source coupled to a second node Vss and a gate coupled to a first portion of the RF signal; and
a second plurality of cascode stages, each stage of the second plurality of cascode stages including a third transistor (730) and a fourth transistor (710), the third transistor having a drain coupled to a third node (760A) and a gate coupled to the bias control circuit, the fourth transistor (710) having a drain coupled to a source of the third transistor, a source coupled to the second node and a gate coupled to a second portion of the RF signal,
wherein an equal number of cascode stages from each of the first and second plurality of cascode stages is biased.

2. The RF transmitter of claim 1, wherein the variable amplifying stage is a variable driver amplifier configured to drive a transformer (570).

3. The RF transmitter of any preceding claim, wherein the first portion of the RF signal is an in-phase signal portion of the RF signal and the second portion of the RF signal is 90° out of phase with respect to the first portion.

4. The RF transmitter of any preceding claim, wherein the bias control circuit biases the equal number of cascode stages from each of the first and second plurality of cascode stages to adjust a respective output current at the first and third nodes.

5. The RF transmitter of any preceding claim, wherein each transistor in each of the cascode stages is approximately the same size.

6. The RF transmitter of any preceding claim 1 to 4, wherein each cascode stage is different in size with respect to each other.

## Patentansprüche

1. Hochfrequenz (HF) -Sender (500) mit:
einer programmierbaren Verstärkerstufe (530), die so konfiguriert ist, dass sie ein differentielles HF-Signal mit einem gegebenen Leistungspegel ausgibt; und
einer variablen Verstärkerstufe (560), die an die programmierbare Verstärkerstufe gekoppelt ist, wobei die variable Verstärkerstufe so konfiguriert ist, dass sie das HF-Signal, das den gegebenen Leistungspegel hat, empfängt und das HF-Signal regelbar verstärkt, um ein verstärktes Signal mit einem variablen Ausgangsleistungspegel zu erzeugen;
**dadurch gekennzeichnet, dass**
die variable Verstärkerstufe aus einer Vielzahl von Kaskodenstufen besteht, wobei jede Stufe der ersten Vielzahl von Kaskodenstufen einen ersten Transistor (740) und einen zweiten Transistor (720) aufweist, wobei der erste Transistor einen Drain aufweist, der an einen ersten Knoten (760B) gekoppelt ist, und ein Gate, das an eine Vorspannungs-Steuerschaltung (750) gekoppelt ist, wobei der zweite Transistor einen Drain aufweist, der an eine Source des ersten Transistors gekoppelt ist, eine Source, die an einen zweiten Knoten Vss gekoppelt ist, und ein Gate, das an einen ersten Abschnitt des HF-Signals gekoppelt ist; und
einer zweiten Vielzahl von Kaskodenstufen, wobei jede Stufe der zweiten Vielzahl von Kaskodenstufen einen dritten Transistor (730) und einen vierten Transistor (710) aufweist, wobei der dritte Transistor einen Drain aufweist, der an einen dritten Knoten (760A) gekoppelt ist, und ein Gate, das an die Vorspannungs-Steuerschaltung gekoppelt ist, wobei der vierte Transistor (710) einen Drain aufweist, der an eine Source des dritten Transistors gekoppelt ist, eine Source, die an den zweiten Knoten gekoppelt ist, und ein Gate, das an einen zweiten Abschnitt des HF-Signals gekoppelt ist,
wobei eine gleiche Anzahl von Kaskodenstufen von jeder der ersten und zweiten Vielzahl von Kaskodenstufen vorgespannt ist.

2. HF-Sender nach Anspruch 1, wobei die variable Verstärkerstufe ein variabler Treiberverstärker ist, der so konfiguriert ist, dass er einen Transformator (570) treibt.

3. HF-Sender nach einem der vorhergehenden Ansprüche, wobei der erste Abschnitt des HF-Signals ein phasengleicher Signalabschnitt des HF-Signals ist und der zweite Abschnitt des HF-Signals ein in Bezug auf den ersten Abschnitt um 90° phasenverschoben ist.

4. HF-Sender nach einem der vorhergehenden Ansprüche, wobei die Vorspannungs-Steuerschaltung die gleiche Anzahl von Kaskodenstufen von jeder der ersten und zweiten Vielzahl von Kaskodenstufen vorspannt, um einen entsprechenden Ausgangsstrom an den ersten und dritten Knoten einzustellen.

5. HF-Sender nach einem der vorhergehenden Ansprüche, wobei jeder Transistor in jeder der Kaskodenstufen ungefähr dieselbe Größe hat.

6. HF-Sender nach einem der vorhergehenden Ansprüche 1 bis 4, wobei jede Kaskodenstufe in Bezug zueinander eine andere Größe hat.

## Revendications

1. Emetteur (500) radiofréquence (RF) comprenant :
un étage de gain programmable (550) configuré pour produire un signal RF différentiel ayant un niveau de puissance donné ; et
un étage d'amplification variable (560) couplé à l'étage de gain programmable, l'étage d'amplification variable étant configuré pour recevoir le signal RF ayant le niveau de puissance donné et amplifier de manière ajustable le signal RF pour générer un signal amplifié ayant un niveau de puissance de sortie variable,
**caractérisé en ce que**
l'étage d'amplification variable est composé d'une première pluralité d'étages cascodes, chaque étage de la première pluralité d'étages cascodes comprenant un premier transistor (740) et un second transistor (720), le premier transistor ayant un drain couplé à un premier noeud (760B) et une grille couplée à un circuit de commande de polarisation (750), le second transistor ayant un drain couplé à une source du premier transistor, une source couplée à un second noeud Vss et une grille couplée à une première partie du signal RF ; et
une seconde pluralité d'étages cascodes, chaque étage de la seconde pluralité d'étages cascodes comprenant un troisième transistor (730) et un quatrième transistor (710), le troisième transistor ayant un drain couplé à un troisième noeud (760A) et une grille couplée au circuit de commande de polarisation, le quatrième transistor (710) ayant un drain couplé à une source du troisième transistor, une source couplée au second noeud et une grille couplée à une seconde partie du signal RF,
dans lequel un nombre égal d'étages cascodes de chacune de la première et de la seconde pluralité d'étages cascodes est polarisé.

2. Emetteur radiofréquence selon la revendication 1, dans lequel l'étage d'amplification variable est un amplificateur variable pilote, configuré pour commander un transformateur (570).

3. Emetteur radiofréquence selon l'une quelconque des revendications précédentes, dans lequel la première partie du signal RF est une partie de signal en phase du signal RF et la seconde partie du signal RF est déphasée de 90° par rapport à la première partie.

4. Emetteur radiofréquence selon l'une quelconque des revendications précédentes, dans lequel le circuit de commande de polarisation polarise le nombre égal d'étages cascodes de chacune de la première et de la seconde pluralité d'étages cascodes pour ajuster un courant de sortie respectif au premier et au troisième noeuds.

5. Emetteur radiofréquence selon l'une quelconque des revendications précédentes, dans lequel chaque transistor dans chacun des étages cascodes est approximativement de la même taille.

6. Emetteur radiofréquence selon l'une quelconque des revendications précédentes 1 à 4, dans lequel chacun des étages cascodes est de taille différente par rapport aux autres.
